Europäisches Patentamt

(19) **European Patent Office**

**Office européen des brevets**

(11) Publication number: **0 154 932**
A2

(12) # EUROPEAN PATENT APPLICATION

(21) Application number: **85102514.8**

(22) Date of filing: **06.03.85**

(51) Int. Cl.⁴: **G 03 F 7/02**, G 03 F 7/20

(30) Priority: **09.03.84 US 586910**

(43) Date of publication of application: **18.09.85**
**Bulletin 85/38**

(84) Designated Contracting States: **DE FR GB**

(71) Applicant: **Hewlett-Packard Company, Mail Stop 20 B-O 3000 Hanover Street, Palo Alto California 94304 (US)**

(72) Inventor: **Watts, Michael P.C., 1104 Pine Street, Menlo Park, CA 94025 (US)**

(74) Representative: **Schulte, Knud, Dipl.-Ing., c/o Hewlett-Packard GmbH Europ. Patent- und Lizenzabteilung Postfach 1430 Herrenberger Strasse 130, D-7030 Böblingen (DE)**

(54) **Multilayer photoresist process.**

(57) A photoetch process of the portable-conformable-mask type is disclosed wherein a thin top layer 5 of resist and a thick planarizing layer 3 of resist are deposited on a substrate 1 and the thin layer 5 is exposed to light and developed to produce a portable-conformable mask. A first dye is dissolved in the bottom layer 3 to absorb light of the wavelengths used to expose the top layer 5 in order to prevent interference with exposure of the top layer 5 by light reflected from the substrate 1. The bottom resist layer 3 absorbs relatively strongly in a wavelength region in which the light source used to expose the bottom resist 3 is relatively intense. A second dye is added to the top layer 5 to make that layer opaque to light of the wavelengths used to expose the bottom layer 3 so that the top layer 5 can serve as a mask for the bottom layer 3. The particular dyes chosen must not interfere with the processing of either resist layer.

2

March 1, 1985

## MULTILAYER PHOTORESIST PROCESS

The invention relates to a process according to the preamble of claim 1 for photoetching a substrate, wherein several layers of photoresist are utilized. A process of that kind is used, for example, for the fabrication of semiconductor chips.

In integrated circuit technology, significant effort has been expended on increasing the resolution of photoresist processes because greater resolution enables a greater number of circuits to be placed on a single chip. This increase in circuit density increases the potential complexity and speed of the resulting integrated circuit.

Present techniques in optical projection printing can resolve 1 micrometer lines in photoresist with good linewidth control when flat, low reflectivity substrates are used. However, when exposing resist on substrates with surface topography, there are resist control problems introduced by optical reflections and by resist thickness non-uniformity.

Reflection of light from the substrate-resist interface produces variatons in the light intensity in the resist during exposure resulting in non-uniform linewidth. Light can scatter from the interface into regions of the resist where no exposure was intended resulting in a broadening or blooming of the linewidth. The amount of scattering and reflection will typically vary from region to region resulting in linewidth non-uniformity.

To eliminate the effects of chromatic aberration in the optical section of the photolithography equipment, monochromatic or quasi-monochromatic light is commonly used in resist projection printing techniques to expose the resist. Unfortunately, the effect of interface reflections on resolution is particularly significant when monochromatic or quasi-monochromatic light is used to expose the resist.

When such light reflects from the substrate-resist interface, the reflected light interferes with incident light to form standing waves within the resist. In the case of highly reflective substrate regions, the standing wave effect is more pronounced. Part of the reflected light also reflects back to the substrate from the top surface of the resist. Such multiple reflections of the incident light between the top and bottom surfaces of the resist layer results in a resonance affecting the light intensity within the resist. The time required to expose the resist is generally an increasing function of resist thickness because of the increased total amount of light required to expose an increased amount of resist. However, because of the resonant effect, the time required for complete exposure also includes a fluctuating component which varies between successive maximum and minimum values as the resist thickness varies through a quarter wavelength of the incident light. If the resist thickness is non-uniform, there will be a non-uniform exposure resulting in variable linewidth control. The photoresist linewidth control problems due to scattering and reflection from the substrate-resist interface can be solved by reducing or eliminating the substrate reflection. In one prior proposal (H.A. Koury and K.V. Patel, "Anti-Interference Phenomena Coating", IBM Technical Disclosure Bulletin, Vol.13, No.1, page 38, June 1970) a thin ultraviolet light absorbing layer containing a dye such as methyl orange or methanil yellow is deposited at the substrate-resist interface.

Linewidth control problems also arise from substrate topography. As indicated above, the resonance effect and resist thickness variation can combine to produce linewidth non-uniformity. In addition, when a layer of resist is exposed and developed, the resulting resist pattern will typically have sloping walls so that the width of the resist pattern at the surface of the substrate will vary with the resist thickness. Because a layer of material deposited on a non-flat surface will inherently vary in thickness, substrate topography will produce linewidth control problems. The problems due to substrate surface topography are addressed in the portable conformable mask (PCM) technique disclosed in the article entitled "Portable conformable mask

0154932

- a hybrid near-ultraviolet and deep-ultraviolet pattering technique "
by B.J. Lin in SPIE Vol.174 Developments in Semiconductor Microlithography IV, page 114 (1979) . In that technique a thick bottom layer
(1-3 micrometer) of polymethyl methacrylate (PMMA) is deposited on the
substrate to produce a substantially planar surface on which a thin
(0.2 micrometer) layer of a second resist is deposited. The top resist
is then exposed (e.g. by a projection printing technique using near-
ultraviolet light or electron beam exposure) and developed to produce
a mask which is opaque to deep-ultraviolet light. The bottom layer of
PMMA is then exposed through the mask with deep-ultraviolet light and
is developed  to produce the desired resist pattern. The polychromatic
deep-ultraviolet exposure reduces the reflection problems associated
with the exposure of the bottom resist layer but the reflection problem is not addressed as it affects the exposure of the top layer. To
further improve line resolution a technique is required which addresses both the problems caused by interface reflectivity and caused
by substrate surface topography.

Recently, a two layer photoresist process was described by M. Chen, W.
Trutna, M. Watts, K. Bartlett, and G. Hillis in a patent entitled
"Multilayer Photoresist Process Utilizing An Absorbant Dye",
US Patent Number 4 362 809 , issued December 7, 1982 which addresses
the problems described above. In that process (which for convenience
herein will be referred to as the PMMA PCM process), a bottom layer of
PMMA is deposited of sufficient thickness (approximately 1,5 micrometer) to produce a substantially planar top surface and then a thin
(less than 1 micrometer) top layer of Kodak 809 is deposited, exposed
through a mask with 436 nm light and developed to produce a portable
conformable mask (PCM). The bottom layer is then exposed with deep UV
light in the range 200-250 nm. The PCM is opaque to light of that
wavelength and therefore upon development of the bottom layer, the PCM
pattern is transferred into the bottom layer. Coumarin 6 dye is included in the bottom layer to absorb light of the wavelength used to
expose the top layer so that linewidth variation in the PCM caused by
interference effects are eliminated. The known process has the disadvantage that the required exposure time for pattern transfer is longer than is suitable for efficient use in a production process. The known process typically requires an exposure time of 10 minutes when using a 500 W Hg/Xe lamp. Typically, a wafer can be processed through a wafer stepper in about 2 minutes and therefore a 10 minute pattern transfer exposure would produce a bottleneck in a production line.

In view of the last-mentioned prior art, the object of the invention is to improve a process of the kind described in the preamble of claim 1 so that the pattern transfer exposure time is substantially reduced without reducing the quality of pattern production in the top and in the bottom layer resists.

According to the invention, this object is solved by the characterizing features of claim 1. An underlying concept of the invention is to use substances as a bottom resist which have a comparatively strong absorbance in the wavelength range where the light source is comparatively intense so that the exposure time can be substantially reduced.

In claim 2, a substance for use in the bottom resist layer is described which renders possible exposure times of about one minute. According to claim 3, the resolution in patterning the top layer can be further improved. If the top resist layer is not sufficiently opaque to light used to expose the bottom resist layer, the development of the invention according to claim 4 ensures that the patterned top layer adequately functions as a mask. The remaining subclaims describe substances and light sources which are advantageous for performing the process according to the invention.

Subsequently, embodiments of the invention are explained with reference to the drawings.

Figure 1    illustrates the top layer exposure step of a process in accordance with the invention.

Figure 2    illustrates the bottom layer exposure step of a process in accordance with the invention.

Figure 3A illustrates the resist pattern which results from a process in accordance with the invention in which the top resist layer has been removed during development of the bottom layer.

Figure 3B illustrates the resist pattern which results from a process in accordance with the invention in which the top resist layer has not been removed during development of the bottom layer.

Figure 4 shows the Hg/Xe lamp spectrum and the absorbance spectra of PMIPK and PMMA.

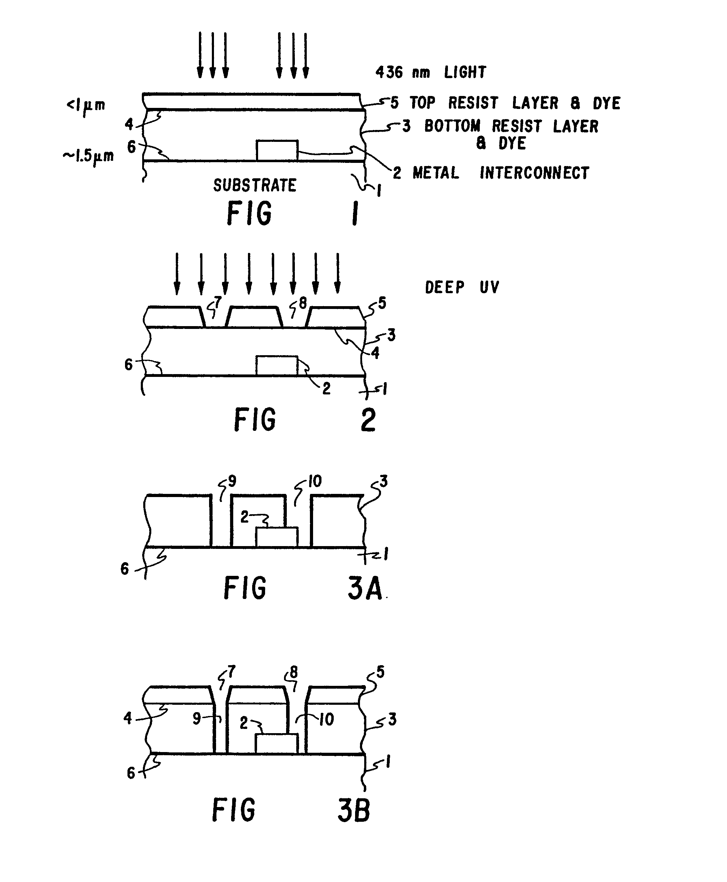

In Figure 1 is shown a substrate on which a metal interconnect 2 has been deposited. Metal interconnects present one of the biggest obstacles to good linewidth resolution in subsequent resist pattern development because such interconnects not only produce problems due to surface topography but also produce local regions of high reflectivity. The substrate is covered with a bottom layer of resist of sufficient thickness to produce a substantially planar surface. A thin top layer of resist is then deposited on top of the planar surface. Preselected portions of the top layer are exposed with light of a first wavelength which has passed through a mask to define the preselected portions. The top layer is developed to produce a portable-conformable-mask (PCM) to be used in patterning the bottom resist layer. The bottom layer is sufficiently absorbant to light at the first wavelength that substantially none of this light is reflected back to the top layer from the interface between the bottom resist and the substrate. This is achieved by the addition to the bottom layer of a dye which is absorbant to light at the first wavelength. In addition, the dye is selected to avoid interference with the exposure and development of the bottom layer.

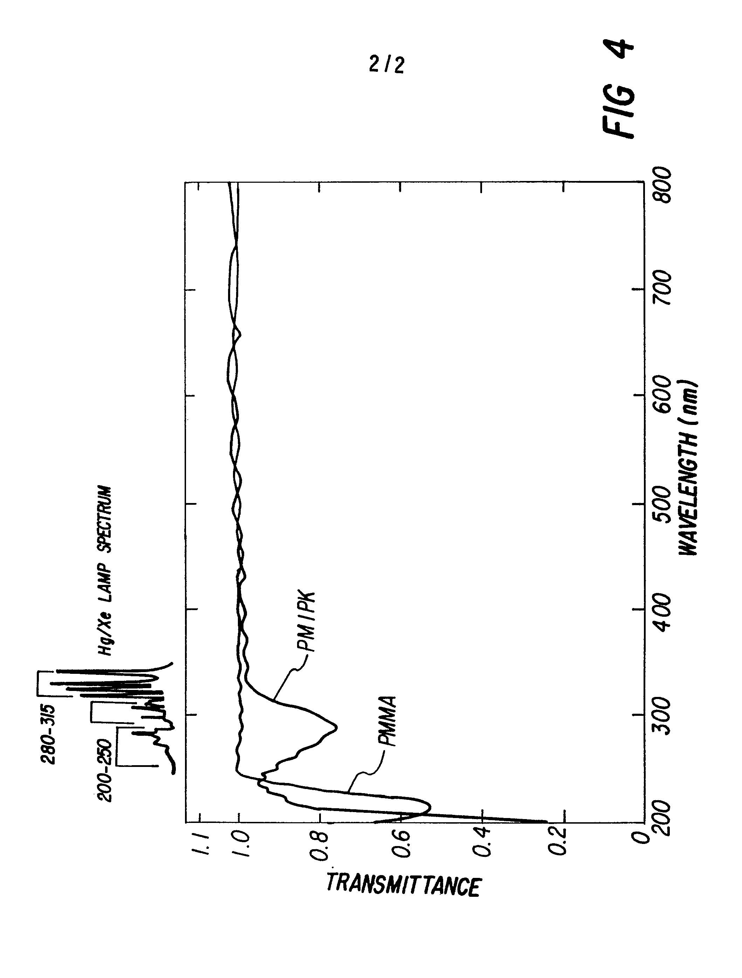

As can be seen by reference to Figure 4, the intensity of the Hg/Xe lamp utilized in the PMMA PCM process discussed above is much more intense in the range from 280-315 nm than in the range from 200-250 nm. Even though there is more than one peak within that range, the range from 280-315 nm is characterized as having a relatively much larger average intensity than in other nearby ranges. PMMA only has significant absorbance in the range from 200-250 nm and is therefore unable to utilize the more intense range from 280-315 nm. Poly methyl isopropenyl ketone (PMIPK) has a reasonable sized absorbance peak at about 300 nm, i.e. in the wavelength range where the intensity of the Hg/Xe lamp is comparatively high. Therefore, PMIPK is a substance which can be used as a bottom resist layer in a process according to the invention. Because PMIPK utilizes the same casting solvent (chlorobenzene) as PMMA, Coumarin 6 is again a suitable choice for addition to the bottom layer to eliminate substantial reflection from the substrate-bottom resist interface.

Kodak 809 is selected for use in the top layer because of the desirable properties that it exhibits in the PMMA PCM process. Unfortunately, a top layer of Kodak 809 would transmit approximately 75% of incident light at 310 nm and therefore the top layer would not be sufficiently opaque at the wavelength used to expose the PMIPK to serve as a PCM once it was patterned. Therefore, a dye is required which has the following properties:

(1) it must absorb strongly in the range from 280-315 nm so that the patterned top layer can function as a mask in exposing the bottom layer;

(2) it should absorb weakly in the range from 350-436 nm so that it transmits light utilized for alignment (typically around 633 nm wavelength) and does not interfere significantly with the exposure of the top layer (e.g., with 436 nm light used in many projection printers or shorter wavelengths being proposed for future projection printers);

(3) it must be retained in the top layer during prebake;

(4) it must be soluble in the top layer casting solvent and in the cast film;

(5) it must not significantly degrade the lithographic performance of the top layer.

A number of dyes were investigated which absorb strongly at 310 nm. The large surface to volume ratio of the top layer makes evaporation of the dye during prebake a problem which made many of these dyes unsuitable. Those dyes that were not soluble in ethyl ethoxy acetate, the casting dye for the top layer, were dissolved in a second solvent and the resulting solution was added to the top layer. This PMIPK bottom layer should not be significantly soluble in the second solvent or else a portion of the PMIPK will dissolve in it producing an intermediate layer which produces ragged resist lines. Methoxy ethanol dissolves many of the polar dyes and does not significantly dissolve PMIPK and is therefore suitable for use as the second solvent.

Many of the dyes were found to significantly affect the lithographic performance of the top layer resist. For example, the addition of 15% dihydroxy benzophenone increased the solubility of the top layer in an alkali developer so that the developer had to be diluted 10-fold to obtain a 1 minute development time for the top resist. In contrast to this, the addition of 20% bis pyridylethylene (BPE) was found to increase the development time by a factor of two. BPE was determined to be the best choice for the dye to be added to the top layer.

In order to preserve the large tolerance to variations in process parameters exhibited by the PMMA PCM process, it is important to preserve the large contrast ratio (i.e., the ratio of the solubility of the exposed resist to the solubility of the unexposed resist) exhibited by PMMA --namely, about 150. In addition it is desired that the development time be approximately 1 minute. These two conditions require that, for a 1.5 micrometer bottom layer, the ideal developer must dissolve the unexposed PMIPK at 1.6 Angstroms/second. Among a wide range of ketones, esters and ether-esters, methyl isobutyl ketone (MIBK) was found to be most suitable, resulting in a development time of about 2 minutes. For this development time and a contrast ratio of 150, the exposure time required is about 90 seconds--which is much closer to the 1 minute time than the 10 minute time required in the PMMA PCM process.

0154932

Subsequently, a preferred embodiment of the invention is explained in further detail.

The multilayer resist process according to the invention illustrated in Figures 1-3 utilizes absorbing dyes to reduce or eliminate problems caused by reflections from the surface of the substrate and to enhance pattern transfer. A bottom layer 3 of Poly-methylisopropenyl ketone (PMIPK) containing 3% by weight coumarin 6 laser dye (manufactured by Eastman Kodak Company, Rochester, New York 14650) is deposited on a substrate 1 having a metal interconnect 2. The bottom layer is sufficiently thick (approximately 1,5 micrometer) to produce a substantially planar top surface 4. The bottom layer is baked for 30 minutes at 160 degrees celsius and then a thin (approximately 1 micrometer) top resist layer 5 of Kodak 809 resist (manufactured by Eastman Kodak Company) containing 20% by weight of bispyridyl ethylene (BPE) dye is deposited on planar surface 4. The Kodak 809 resist is opaque in the 290-310 nanometer region where PMIPK is sensitive so that after development, the top layer acts as a contact mask for the bottom layer. The top layer is baked for 30 minutes at 80 degrees celsius in a nitrogen atmosphere before exposure to pattern the top layer.

Figure 1 illustrates the processing step in which the top layer 5 is exposed by light from a 436 nanometer projection printer. The PMPIK is not sensitive at this wavelength so that this light is only effective in exposing top resist layer 5. At an exposure intensity of about 1 mW/cm$^2$ the coumarin dye is sufficiently concentrated in the bottom layer and is sufficiently absorbtive at the 436 nanometer wavelength that 20% of the light entering bottom layer 3 is absorbed in a single pass through that layer. The absorption band of coumarin 6 is narrow and it does not significantly absorb in the visible range so that its presence does not interfere with viewing the alignment marks on the substrate during projection printing alignment.

The absorption of the 436 nanometer light by the dyed bottom resist layer improves linewidth resolution in the top layer 5 by reducing reflections from the interface 6 between the substrate 1 and the bottom resist layer 3. Therefore good linewidth control is preserved when the top layer 5 is developed to produce the portable conformable mask. The top layer is developed by immersion for 60 seconds in Kodak 809 developer followed by a rinse with deionized water.

In Figure 2 the bottom layer is exposed through the developed regions such as 7 and 8 in the top resist layer 5 with deep-ultraviolet light in the range of 290-310 nanometers. The dye contained in the top layer is absorbent at 300-310, which is required for pattern transfer. The bottom layer accurately replicates the top layer pattern for a number of reasons. First, the broad band deep-ultraviolet exposure of the bottom layer reduces standing wave and resonance effects within the bottom layer. Secondly, the reflectivity of most materials decreases at the deep-ultraviolet wavelengths used for PMIPK exposure. In addition, the high frequencies employed reduce diffraction and result in high contrast exposure of the bottom layer. To preserve the high contrast it is important that the dye does not absorb strongly at the high frequencies employed in the PMIPK development. Unfortunately, Coumarin does absorb somewhat in the 290-310 nanometer region. However, it does not absorb strongly enough to significantly degrade linewidth resolution. With about a factor of two increase in ultraviolet exposure time the dyed PMPIK produces the same vertical sidewalls as undyed PMIPK. The top layer is redeveloped in a solution of MX 931 from Kodak followed by a rinse with deionized water to remove any remaining Kodak 809, leaving a residue free PMIPK layer. The bottom layer is then developed in a solution of MIBK for 2 minutes. The structure resulting from this development step is shown in Figure 3A. Other developers, such as chlorobenzene, which can be used to develop the bottom layer, leave the top layer intact resulting in a structure like that shown in Figure 3B.

The BPE dye content in the top layer may be varied to maintain a minimum transmission in the top layer that is required to give good quality pattern transfer. If the top layer is very thin (less than 1 micrometer), the BPE content must be increased to maintain a transmission of less than 0,5 % (a transmission of less than 0,5 % guarantees accurate pattern transfer with no interference).

March 1, 1985

CLAIMS

1.  A process of photoetching a substrate (1) of the portable-
    conformable-mask type in which
    - a plurality of layers, including a top resist layer (5) and a
      bottom resist layer (3) which is thick enough to have a substantially planar top surface (4), are deposited on the substrate to produce a multilayer substrate coating having the bottom resist layer sandwiched between the substrate and the top
      resist layer,
    - the top resist layer is exposed to light in a range of
      wavelengths in which the bottom resist layer is insensitive,
      said light having been passed through a mask to expose only selected portions of the top resist layer,
    - the top resist layer is developed to produce a portable-
      conformable- mask, and
    - the layers of the substrate coating other than the top resist
      layer are processed to replicate the pattern of this portable-
      conformable-mask into such layers,
    c h a r a c t e r i z e d  in that
    the step of replicating the pattern of the portable-conformable-
    mask into the bottom resist layer (3) comprises the steps of:
    - exposing the bottom resist layer with light having such a spectral distribution that the average light intensity is largest in
      a range of wavelengths in which the bottom resist has a stronger
      absorbance than in other wavelength ranges, and
    - developing the bottom resist layer.

2.  A process as in claim 1,
    c h a r a c t e r i z e d  in that the bottom resist comprises
    poly methyl isopropenyl ketone (PMIPK).

3. A process as in claim 2,
c h a r a c t e r i z e d  in that Coumarin 6 dye is included in the bottom resist layer.

4. A process as in any of the claims 1 through 3,
c h a r a c t e r i z e d  in that a dye is included in the top resist layer (5), said dye absorbing strongly in the range of wavelengths used to expose the bottom resist layer (3).

5. A process as in claim 4,
c h a r a c t e r i z e d  in that the dye included in the top resist layer (5) is bispyridyl ethylene (BPE).

6. A process as in any of the preceding claims,
c h a r a c t e r i z e d  in that the top resist layer (5) comprises KODAK 809.

7. A process as in any of the preceding claims,
c h a r a c t e r i z e d  in that the top layer (5) is exposed with light of a wavelength of 436 nm.

8. A process as in any of the preceding claims,
c h a r a c t e r i z e d  in that the bottom layer (3) is exposed with light in the range from 290 nm to 310 nm.

9. A process as in any of the preceding claims,
c h a r a c t e r i z e d  in that the bottom layer (3) is exposed with light from a Hg/Xe lamp.

**436 nm LIGHT**

**5 TOP RESIST LAYER & DYE**

**3 BOTTOM RESIST LAYER & DYE**

**2 METAL INTERCONNECT**

<1 μm

~1.5μm

SUBSTRATE

**FIG 1**

**DEEP UV**

**FIG 2**

**FIG 3A**

**FIG 3B**

2/2

FIG 4

0154932